Europäisches Patentamt

European Patent Office

Office européen des brevets

(19)

(11) Veröffentlichungsnummer : **0 059 770**
**B1**

(12) # EUROPÄISCHE PATENTSCHRIFT

(45) Veröffentlichungstag der Patentschrift :
21.11.85

(21) Anmeldenummer : 81101691.4

(22) Anmeldetag : 07.03.81

(51) Int. Cl.⁴ : **G 01 R 33/04**

(54) Vorrichtung zum Erfassen eines Magnetfeldes.

(43) Veröffentlichungstag der Anmeldung :
15.09.82 Patentblatt 82/37

(45) Bekanntmachung des Hinweises auf die Patenterteilung : 21.11.85 Patentblatt 85/47

(84) Benannte Vertragsstaaten :
DE FR GB IT

(56) Entgegenhaltungen :
DE-A- 2 353 039
DE-A- 2 434 374
DE-A- 2 539 455
DE-B- 1 773 303
US-A- 2 815 499
Die Akte enthält technische Angaben, die nach dem
Eingang der Anmeldung eingereicht wurden und die
nicht in dieser Patentschrift enthalten sind.

(73) Patentinhaber : TELDIX GmbH
Grenzhöfer Weg 36 Postfach 105608
D-6900 Heidelberg 1 (DE)

(72) Erfinder : Wehde, Heinz, Dr. rer. nat.
Landwehrstrasse 30
D-6121 Rothenberg (DE)
Erfinder : Kiesewetter, Hermann
Stahlbühlring 67
D-6802 Ladenburg (DE)
Erfinder : Klotz, Hermann, Dipl.-Ing.
Edinger Strasse 21
D-6900 Heidelberg (DE)
Erfinder : Rogge, Joachim, Dr. Ing.
Am Hang 7
D-6922 Meckesheim (DE)

(74) Vertreter : Kammer, Arno, Dipl.-Ing.
TELDIX GmbH Postfach 10 56 08 Grenzhöfer Weg 36
D-6900 Heidelberg 1 (DE)

**Beschreibung**

Die Erfindung bezieht sich gemäß Oberbegriff des ersten Patentanspruches auf eine aus der DE-B-1 773 303 bekannte Vorrichtung zum Erfassen eines Magnetfeldes bzw. zum Messen des magnetischen Flusses eines externen Magnetfeldes, insbesondere des Erdmagnetfeldes.

Grundsätzlich kann mittels einer derartigen Vorrichtung ein Magnetfeld, welches in der durch den Kern und die genannten Spulen vorgegebenen Meßebene wirkt, erfaßt werden. Wird die Meßebene durch pendelnde Anordnung des Kerns und gegebenenfalls der Spulen in einer horizontalen Ebene gehalten, so kann insbesondere die Richtung der Horizontalkomponente des Erdmagnetefeldes bestimmt bzw. ein Signal entsprechend der Nordrichtung erzeugt werden. In der bekannten Vorrichtung ist der Kern von einer gleichmäßig um diesen gewickelten Erregerspule umgeben, welche mitels einer periodischen Spannung bzw. eines periodischen Stroms derart angesteuert wird, daß der Kern weit genug in den Sättigungsbereich ausgesteuert wird. Die vier Abgriffspulen sind über den Umfang um jeweils 90° gegeneinander versetzt angeordnet, wobei die einander diametral gegenüberliegenden Abgriffspulen gegeneinander geschaltet sind. Durch Differenzbildung in diesen Abgriffspulenpaaren hebt sich in diesen grundsätzlich die transformierte Spannung auf. Ein externes Magnetfeld, insbesondere die Horizontalkomponente des Erdmagnetfeldes, bewirkt jedoch eine Verschiebung des Arbeitspunktes auf der Magnetisierungskennlinie. Damit verbunden ist eine Phasenverschiebung, die einen sich nicht aufhebenden Spannungsanteil zur Folge hat. Dieser besteht im wesentlichen aus Harmonischen gerader Ordnung der Erregerfrequenz, wobei deren Amplituden dem externen Magnetfeld proportional sind. In der mit den Abgriffspulen verbundenen Auswerteschaltung wird zweckmäßigerweise die zweite Harmonische ausgewertet, um ein der Richtung des externen Magnetfeldes entsprechendes Signal zu erzeugen. Die Herstellung einer derartigen Vorrichtung wirft aber eine Reihe von Problemen auf, da infolge von Inhomogenitäten und Unsymmetrien im Kern und in den Spulen auch Störspannungen auftreten. Die bekannte Vorrichtung enthält außerdem eine Vielzahl von Bauelementen, u. a. eine aus einem oberen Teil und einem unteren Teil bestehende spulenform, welche mit nicht unerheblichem Aufwand gefertigt und justiert werden müssen. Außerdem ist zur Aufnahme des Kerns ein relativ großer Hohlraum im Spulenkörper erforderlich, um die pendelnd aufgehängte Vorrichtung nicht in ihrer Beweglichkeit zu beschränken.

Aus der DE-A-2 539 455 ist ferner eine Vorrichtung bekannt, in welcher drei Abgriffspulen auf radialen Armen des Kernes aus hochpermeablem Material sternförmig angeordnet sind, wobei ebenfalls eine pendelnde Aufhängung zur Erfassung des Erdmagnetfeldes vorgenommen ist.

Die Auswerteschaltung enthält ein aufwendiges Signal-Meßfühlersystem mit einem dreiphasigen Stator sowie Verstärkereinrichtungen zur Auswertung der zweiten Harmonischen. Zur Kompensation der Grundfrequenz und der dritten Harmonischen, insbesondere aufgrund einer magnetischen Unsymmetrie des Kernes, müssen zusätzliche Maßnahmen getroffen werden, welche einen erheblichen Zeit- und Kostenaufwand erfordern. Darüber hinaus sind infolge der radialen Anordnung der Abgriffspulen einer Miniaturisierung der Vorrichtung Grenzen gesetzt.

Der Erfindung liegt daher die Aufgabe zugrunde, eine Vorrichtung der eingangs genannten Art derart auszubilden, daß sie mit einem geringen Fertigungsaufwand herstellbar ist und daß eine gute Reproduzierbarkeit der Signale auch ohne aufwendige Justier- und Abgleicharbeiten gewährleistet wird, wobei auch für die Ansteuerung und Auswerteschaltung ein kostengünstiger Aufbau erreicht werden soll.

Diese Aufgabe wird durch die im Kennzeichen des ersten Patentanspruches angegeben Merkmale gelöst.

Die erfindungsgemäße Vorrichtung zeichnet sich vor allem durch einen einfachen und kostengünstigen Aufbau aus und gewährleistet auch bei sehr kleinen Abmessungen eine sehr genaue Erfassung des externen Magnetfeldes. Ein wesentlicher Gesichtspunkt ist hierbei, daß durch das Einlegen des Ringkernes in den Spulenkörper und Anordnung des Spulen auf dem Spulenkörper in Nuten ein sehr exakter, symmetrischer Aufbau erreicht wird.

Es ist zwar aus der DE-A-2 434 374 eine Magnetfeldsonde bekannt, die neben der Horizontalkomponente des Erdmagnetfeldes auch die Vertikalkomponente derselben mißt. Hierzu sind mehrere Doppelspulenanordnungen nötig, die mit jeweils einem Unterteilungsflansch zur Trennung der einzelnen Spulenstränge versehen sind. Der Unterteilungsflansch stellt jedoch keine notwendige Maßnahme zum bezugsrichtungsgebenden Fixieren der Spulen dar, ist also nur eine mechanische Befestigung der Spulen.

Ebenso zeigt ein in der US-A-2 815 499 dargestellter Magnetfeldsensor die Einbettung eines Kerns in mehrere magnetische Kernschalen, die ein aufwendiges Fertigungsverfahren beanspruchen.

Weiterbildungen der Erfindung sind in den Ansprüchen 2 bis 10 aufgeführt.

In die durch die Nuten gebildeten Kammern sind die Spulen derart gewickelt, daß die Hauptachsen der Abgriffspulen um jeweils 90° versetzt in horizontaler Ebene liegen. Der Spulenkörper ist weiterhin mit zwei nach oben gerichteten Bügeln versehen, in deren Buchsen zwei Wellen eines Kardanringes eingreifen, wobei letzterer mittels zweier um 90° versetzter Wellen in entsprechenden Buchsen eines das Gehäuse abschließenden Deckels gelagert ist. Hierdurch ist mit wenigen Bauelementen eine Kardanlagerung für die pendelnd aufgehängten Spulen und den Kern geschaffen, welche eine einfache Herstellung und Montage gewährleistet.

Als Kern wird eine einzige Ringscheibe aus hochpermeablem Material eingesetzt. In einer vorteilhaften Ausführungsform wird eine Ringscheibe mit einem Innendurchmesser in der Größenordnung von 20 mm und einem Querschnitt in der Größenordnung von 0,1 mm² verwendet. Es wurde nämlich erkannt, daß das Feld im Innern eines in einem homogenen Magnetfeld befindlichen Ringkernes nicht — wie zu erwarten wäre — mit dem Quadrat des Klerndurchmessers anwächst. Ursache hierfür ist der durch Grenzflächenentladungen bedingte Entmagnetisierungsfaktor, welcher bei einem Ringkern sehr ungünstig ist. Bei derartigen Ringkernen konnte vielmehr eine nahezu lineare Abhängigkeit zwischen Kerndurchmesser und innerer Induktion bzw. Empfindlichkeit festgestellt werden, wobei für die oben genannten Abmessungen noch eine gute Empfindlichkeit erreicht wurde. Hierdurch wird eine wesentliche Voraussetzung für die Miniaturisierung der Vorrichtung geschaffen, welche in einer Ausführungsform einen Außendurchmesser um etwa 40 mm aufweist. Um einen derartigen Ringkern voll in die Sättigung auszusteuern, genügt ein Erregerstrom mit einer Amplitude von etwas mehr als 100 mA, was im Hinblick auf den Schaltungsaufwand von Vorteil ist.

Um eine hohe Genauigkeit zu erzielen, enthält die Auswerteschaltung bevorzugt ein hochselektives Filter, durch welches die zweite Harmonische als Nutzsignal aus den Signalspannungen der Abgriffspulen gefiltert wird. Zweckmäßigerweise werden die Signalspannungen mittels geeigneter Schalter abwechselnd auf ein und dasselbe Filter gegeben. Die Auswerteschaltung enthält ferner einen phasenempfindlichen Gleichrichter, zur Erzeugung von Signalen, welche nach Betrag und Vorzeichen der das jeweilige Abgriffspulenpaar durchsetzenden Magnetfeldkomponente entsprechen. Es ist weiterhin ein Oszillator mit nachgeschalteten Teilern vorgesehen, um einerseits eine frequenzstabile Erregerspannung und andererseits die notwendigen Steuersignale für die Schalter vor dem Filter sowie den phasenempfindlichen Gleichrichter zu erhalten. Da die Spulenpaare zueinander einen Winkel von 90° aufweisen, sind die genannten Signale über Sinus bzw. Cosinus vom Einfallswinkel des Magnetfeldes abhängig, so daß schließlich durch eine arctan-Rechnung der Einfallswinkel erhalten wird. Durch die phasenempfindliche Gleichrichtung wird die Restspannung der Signalspannungen wirksam unterdrückt. Sofern das genannte Filter aus mehreren Einzelfiltern aufgebaut ist, können diese gleichspannungsmäßig gekoppelt sein, da Nullpunktsfehler von in diesen enthaltenen Operationsverstärkern durch die phasenempfindliche Gleichrichtung herausfallen. Der wesentliche Vorteil einer derartigen Auswerteschaltung wird darin gesehen, daß keinerlei Abgleich erforderlich ist und auch eine Temperatur- oder Langzeitdrift keine Verfälschung des Meßergebnisses zur Folge hat. Weitere Vorteile der erfindungsgemäßen Vorrichtung ergeben sich aus dem Ausführungsbeispiel.

Die Erfindung wird nachfolgend anhand des in der Zeichnung dargestellten Ausführungsbeispieles näher erläutert. Es zeigen

Figur 1  einen Längsschnitt durch die Vorrichtung, wobei Pendelkörper und Kardanring teilweise in Ansicht dargestellt sind,

Figur 2  eine Aufsicht auf den Spulenkörper,

Figur 3  einen Wirkschaltplan der Auswerteschaltung,

Figur 4  den zeitlichen Verlauf verschiedener Signale in der Auswerteschaltung.

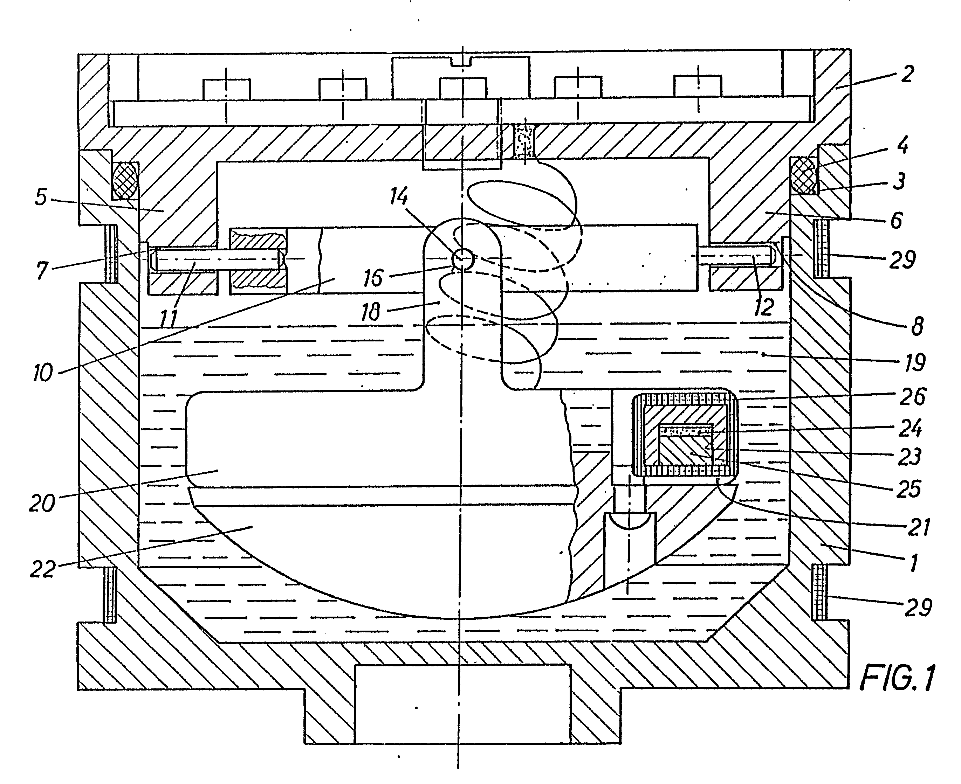

Gemäß Figur 1 enthält die Vorrichtung ein topfförmiges Gehäuse 1, welches oben mittels eines Deckels 2 abgeschlossen ist, wobei zur Abdichtung in eine Ringnut 3 ein O-Ring 4 eingelegt ist. Der Deckel 2 weist zwei diametral gegenüberliegende und nach unten gerichtete Ansätze 5, 6 auf, in deren Buchsen 7, 8 zwei mit einem Kardanring 10 verbundene Wellen 11, 12 aus nichtmagnetischem Stahl eingreifen. Der Kardanring 10 enthält zwei weitere senkrecht zur Zeichenebene angeordnete Wellen 13, 14, welche in Buchsen 15, 16 von zwei diametral gegenüberliegenden Bügeln 17, 18 eingreifen, wobei in Figur 1 nur die Welle 14, die Buchse 16 sowie der Bügel 18 dargestellt sind. Die genannten Bügel 17, 18 sind Bestandteile eines schematisch dargestellten Spulenkörpers 20, welchem an der Unterseite ein Deckel 21 zugeordnet ist. Es ist somit mit wenigen Bauteilen eine Kardanlagerung für die nachfolgend zu beschreibenden Teile geschaffen, so daß die Meßebene sich immer in der horizontalen Ebene befindet. Hierbei ist von besonderer Bedeutung, daß die Durchmesser der genannten Buchsen 7, 8, 15 und 16 einen um etwa 20 % größeren Durchmesser als die jeweiligen Wellen aufweisen, so daß die derart ausgebildeten Lager nur eine geringe Restreibung aufweisen. Das erhebliche Lagerspiel wird durch das unten am Spulenkörper 20 angeordnete, etwa kugelabschnittförmige Pendelgewicht 22 eliminiert. Zur Schwingungsdämpfung des derart kardanish ausgehängten Pendels ist das Gehäuse 1 teilweise mit Dämpfungsöl 19 gefüllt. Der Deckel 2 und der Spulenkörper 20 bestehen aus einem hochfesten, nicht magnetischen Kunststoff. In den genannten Lagern bzw. in den aus dem genannten Kunststoff bestehenden Buchsen 7, 8, 15 und 16 konnten auch nach eingehenden Belastungsprüfungen keine die Rückstellgenauigkeit nachteilig beeinflußenden Veränderungen festgestellt werden.

Der im wesentlichen ringförmige Spulenkörper 20 weist innen eine Ringnut 23 zur Aufnahme eines Kernes 24 aus magnetischem, hochpermeablem Material auf. Der Kern 24 ist als eine einzige dünne Ringscheibe mit einem Querschnitt von etwa 0,1 mm² und einem Innendurchmesser von etwa 20 mm ausgebildet. In die Ringnut 23 ragt außerdem ein ringförmiger Ansatz 25 des Deckels 21 zur Fixierung des Kernes 24. Um den Spulenkörper 20 und den mit diesem beispielsweise durch Kleben verbundenen Deckel 21 sind Windungen 26 der im einzelnen noch zu beschreibenden Spulen gewickelt. Auf der Außenseite des Gehäuses 1 sind zwei Wicklungen einer Helmholtzspule 29 angeordnet, welche von einem Gleichstrom durchflossen wird. Die Helmholtzspule 29 dient zur Kompensation der vertikalkomponente eines Dauermagnetfeldes, welches insbesondere durch ein die Vorrichtung aufnehmendes Fahrzeug verursacht wird. Ein derartiges Dauermagnetfeld kann in der Vorrichtung zu Fehlern für die zu erfassende Horizontalkomponente des Erdmagnetfeldes führen, und mittels der Helmholtzspule 29 lassen sich derartige Fehler weitgehend vermeiden. Über das Gehäuse 1 ist von oben eine hier nicht dargestellte Schutzkappe geschoben. Ferner sind mit dem Gehäuse geeignete Halterungen zur Befestigung beispielsweise auf dem Dach eines Fahrzeuges verbunden.

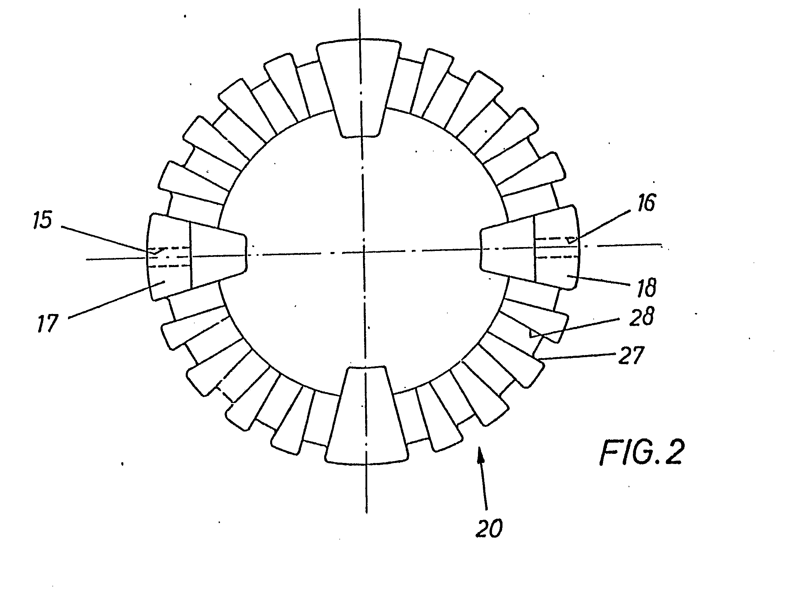

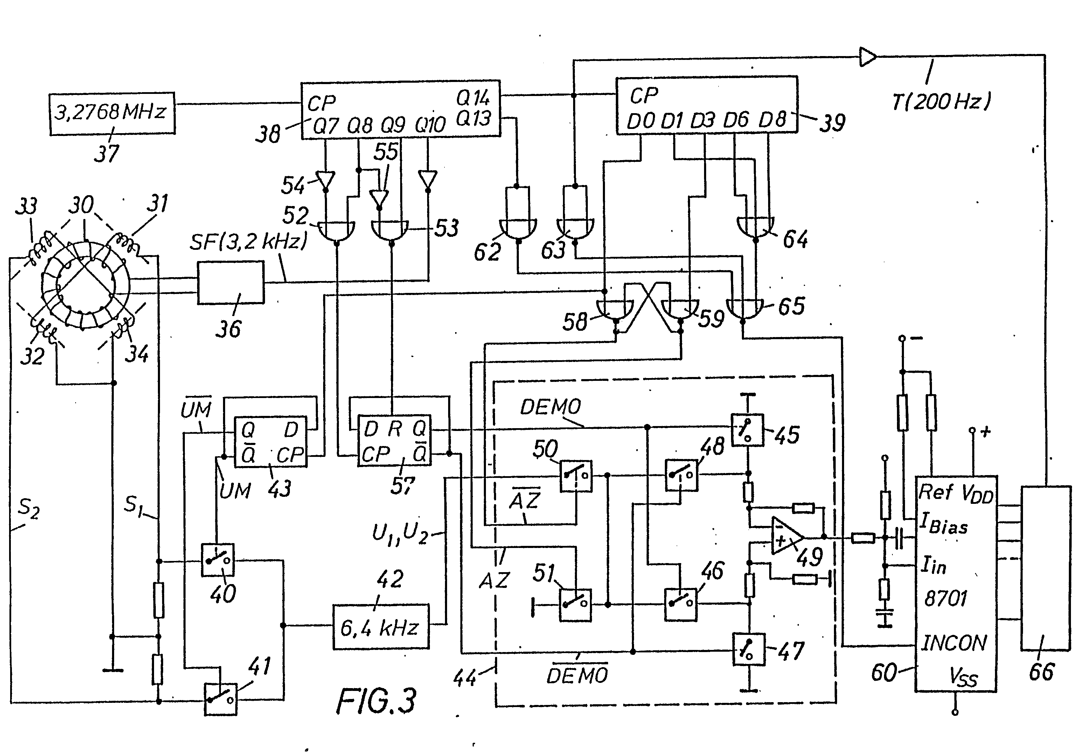

Aus der Aufsicht auf den Spulenkörper 20 gemäß Figur 2 (90° gegen Figur 1 gedreht) ist ersichtlich, daß der Spulenkörper 20 an seinen Außenflächen eine Anzahl von radial bzw. axial verlaufenden Nuten 27 bzw. 28 aufweist. In entsprechender Weise sind auch im Deckel 21 Nuten vorgesehen. In jedem der vier Quadranten ist die gleiche Anzahl (hier fünf) von Nuten 27, 28 eingearbeitet, wobei die genannten Nuten in jedem Quadranten in gleicher Weise angeordnet sind. In die durch die genannten Nuten 27, 28 gebildeten Kammern sind die Erregerspule 30 sowie die Abgriffspulen 31 bis 34 gewickelt (siehe Fig. 3). Hierbei sind die Windungen der Erregerspule 30 gleichmäßig über den Umfang verteilt angeordnet, so daß in jeder der Nuten 27, 28 gleich viele Windungen vorhanden sind. Die Windungen einer der Abgriffspulen 31 bis 34 sind jeweils nur in den Nuten 27, 28 eines Quadranten angeordnet. Aufgrund der symmetrischen Anordnung der Nuten 27, 28 sowie der symmetrischen Ausbildung der Abgriffspulen wird gewährleistet, daß die Hauptachsen der Abgriffspulen in der Meßebene auch exakt um jeweils 90° gegeneinander versetzt liegen.

In den Wirkschaltplan gemäß Figur 3 ist auch die prinzipielle Anordnung der Erregerspule 30 sowie der Abgriffspulen 31 bis 34 dargestellt. Die Erregerspule 30 ist weitgehend gleichmäßig über den Umfang des Kernes 24 angeordnet, während die Abgriffspulen 31 bis 34 jeweils um 90° versetzt angeordnet sind. Aus Gründen der Übersichtlichkeit sind die Spulen 31 bis 34 neben dem Kern 24 gezeichnet, doch sie sind tatsächlich ebenfalls um den Kern 24 gewickelt. Die diametral einander gegenüberliegenden Abgriffspulen 31, 32 bzw. 33, 34 sind unter Berücksichtigung des Wickelsinns jeweils gegeneinander geschaltet, so daß, falls kein externes Magnetfeld einwirkt, durch Differenzbildung in den Spulenpaaren 31, 32 bzw. 33, 34 keine Signalspannung auftritt. Die Erregerwicklung 30 wird von einer Ansteuerschaltung 36 mit einer periodischen, dreieckförmigen Steuerspannung mit einer Amplitude von etwa 2,5 $V_{ss}$ gespeist, wobei ein Strom von etwa 250 $mA_{ss}$ ausreicht, um den einen äußerst kleinen Querschnitt aufweisenden Kern 24 voll in die Sättigung auszusteuern. Die Ansteuerschaltung 36 enthält zweckmäßigerweise einen Regler mit integralem Verhalten zur Stromamplitudenregelung. Der Ansteuerschaltung 36 wird ein frequenzstabiles Signal SF von 3,2 KHz zugeführt, welches über einen Teiler 38 (Dualzähler) aus der Impulsfolge eines Oszillators 37 gebildet wird. Der Oszillator 37 enthält einen Schwingquarz mit einer Frequenz von 3,2768 MHz. Die genannte Impulsfolge wird auf den Zähleingang CP des nachgeschalteten Teilers 38 geführt, und das am Ausgang Q 10 abgegriffene Signal SF weist eine um den Faktor $2^{10}$ geteilte Frequenz von 3,2 KHz auf, welche somit die Grundfrequenz des Erregerstromes ist. Es sei besonders darauf hingewiesen, daß nicht nur die Frequenz des Erregerstromes, sondern auch die der im einzelnen noch zu erläuternden Steuersignale direkt aus der Frequenz des Oszillators 37 mittels der Teiler 38, 39 abgeleitet wird.

Ist in der Meßebene ein externes Magnetfeld wirksam, so treten in den Abgriffspulenpaaren 31, 32 bzw. 33, 34 Signalspannungen $S_1$ und $S_2$ auf, wobei die Amplituden der zweiten Harmonischen ($U_1$, $U_2$) den in Richtung der Spulenhauptachsen liegenden Feldvektorkomponenten proportional sind und die Phasenlagen dieser Signalspannungen die Richtung der Feldvektorkomponenten beinhalten. Den Spulenpaaren ist über Analogschalter 40, 41 ein Filter 42 nachgeschaltet, welches nur für die zweite Harmonische, d. h. für Frequenzen von 6,4 KHz durchlässig ist. Die Steuersignale UM und UM für die Schalter 40, 41 werden aus der Impulsfolge des Oszillators 37 abgeleitet. Hierzu ist der Ausgang Q 14 (Faktor $2^{14}$, 200 Hz) mit dem Zähleingang CP eines weiteren Teilers 39 verbunden, an dessen Ausgang DO ein Signal mit 20 Hz ansteht. Der Ausgang DO ist auf eine bistabile Kippstufe 43 geführt, welche nach jeweils 50 Millisekunden die Steuersignale UM bzw. UM abgibt. Die Spulenpaare 31, 32 bzw. 33, 34 sind somit abwechselnd für jeweils 50 Millisekunden mit dem Filter 42 und dem nachgeschalteten phasenempfindlichen Gleichrichter 44 verbunden. Der besondere Vorteil dieser Umschaltung der Spulenpaare liegt vor allem darin, daß die nachgeschalteten Bauelemente wie Filter 42, phasenempfindliche Gleichrichter 44 usw. nur einmal vorhanden sein müssen und daß Parameteränderungen, wie zum Beispiel Temperatur- und Langzeitdrift, auf beide Signalspannungen den gleichen Einfluß haben und somit das Meßergebnis praktisch nicht verfälschen.

Der phasenempfindliche Gleicherichter 44 enthält vier Analogschalter 45 bis 48, welche durch die Steuersignale DEMO bzw. DEMO angesteuert werden, einen Verstärker 49, sowie zwei weitere Analogschalter 50, 51, welche durch die Steuersignale AZ bzw. AZ angesteuert werden. Die Analogschalter 45 bis 48 werden derart angesteuert, daß der Verstärker 49 einmal die Verstärkung + 1 und zum anderen die Verstärkung

– 1 aufweist, wobei die Schaltfrequenz auf die Frequenz der zugeführten zweiten Harmonischen $U_1$ bzw. $U_2$ der Erregerfrequenz abgestimmt ist, d. h., 6,4 KHz beträgt.

Hierzu werden die Steuersignale DEMO bzw. $\overline{DEMO}$ von den Signalen an den Ausgängen Q 7 bis Q 9 des Teilers 38 über NOR-Gatter 52, 53, Inverter 54, 55 sowie eine Kippstufe 57 abgeleitet. Es ist ersichtlich, daß der Kippstufe 57 am Eingang CP Signale mit einer Frequenz von 12,8 KHz zugeführt werden und somit die genannten Steuersignale die erforderliche Frequenz von 6,4 KHz aufweisen. Sind beispielsweise während der ersten Periodenhälfte der zweiten Harmonischen durch das Signal DEMO die Analogschalter 45 und 46 geschlossen, so beträgt die Verstärkung + 1. Während der zweiten Periodenhälfte beträgt die Verstärkung hingegen – 1 infolge der nunmehr durch das Signal $\overline{DEMO}$ geschlossenen Analogschalter 47 und 48. Da die zweite Harmonische $U_1$ bzw. $U_2$ einem im wesentlichen sinusförmigen Verlauf aufweist, erscheint somit am Ausgang des Verstärkers 49 ein vollweggleichgerichtetes Signal entsprechend der Amplitude der zweiten Harmonischen mit – je nach Phasenlage – positivem oder negativem Vorzeichen. Dies gilt unter der Voraussetzung, daß durch das Steuersignal $\overline{AZ}$ der Analogschalter 50 am Eingang des phasenempflindlichen Gleichrichters 44 geschlossen ist. Mittels des anderen Analogschalters 51 kann durch das Steuersignal AZ der Eingang auf Masse gelegt werden (Auto-Zero-Phase). Die genannten Steuersignale werden von Signalen an den Ausgängen D0 und D3 des Teilers 39 über eine Kippstufe 58, 59 abgeleitet, wie es weiter unten erläutert wird.

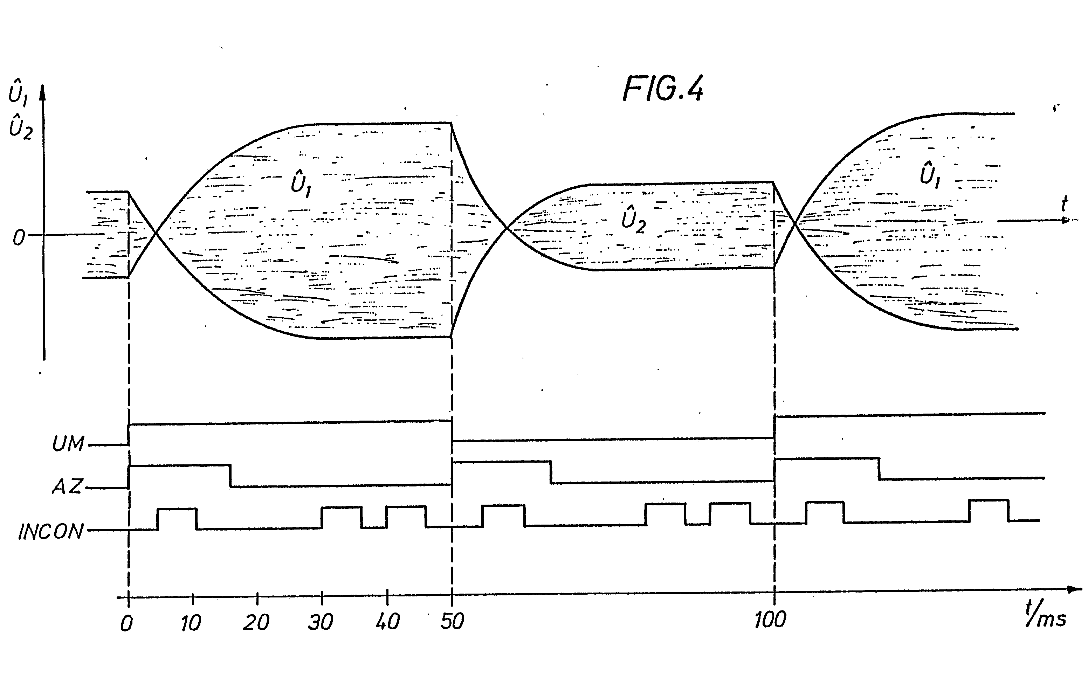

Dem Phasenempfindlichen Gleichrichter 44 bzw. dessen Verstärker 49 ist ein Analog-Digital-Wandler 60 nachgeschaltet. Es ist bevorzugt ein 10-Bit-Wandler vorgesehen, welcher nach dem Charge-Balancing-Verfahren arbeitet. Da das Eingangsignal bzw. die Eingangsspannung sowohl ein negatives als auch positives Vorzeichen aufweisen kann, der A/D-Wandler jedoch nur positive Signale verarbeiten kann, wird über einen Vorstrom $I_{Bias}$ der Wandlerbereich um ungefähr den halben Wertebereich verschoben, wodurch sich die Auflösung auf 9 Bit erniedrigt. Die A/D-Wandlung wird zu vorgegebenen Zeiten durch ein weiteres Steuersignal INCON ausgelöst, um das Eingangssignal umzuformen und über die Digital-Ausgänge des A/D-Wandlers in einen nachgeschalteten Rechner 66 zu geben. Das Steuersignals INCON wird aus Signalen an den Ausgängen Q 13, Q 14 des Teilers 38 sowie an den Ausgängen D1, D6, D8 des Teilers 39 über NOR-Gatter 62 bis 65 abgeleitet, wobei der zeitliche Verlauf aus Fig. 4 entnehmbar ist. Dem Rechner 66 wird ein Steuer- bzw. Taktsignal von 200 Hz zugeführt, welches am Ausgang Q 14 des Teilers ansteht.

In Figur 4 sind der zeitliche Verlauf der zweiten Harmonischen $U_1$, $U_2$ am Ausgang des Filters 42 sowie der Steuersignale UM, AZ und INCON dargestellt. Die negierten Steuersignal UM und $\overline{AZ}$ ergeben sich als Negation der Steuersignale $\overline{UM}$ und $\overline{AZ}$. Durch das Steuersignal UM wird der Analogschalter 40 für 50 ms geschlossen, und die Signalspannung S 1 wird auf das Filter 42 gegeben, so daß an dessen Ausgang die zweite Harmonische $U_1$ ansteht. Während das Filter 42 auf $U_1$ einschwingt, wird durch AZ mittels des Analog-Schalters 51 für etwa 15 ms der Eingang des phasenempfindlichen Gleichrichters auf Masse gelegt. In dieser Auto-Zero-Phase erscheint hier etwa 5 ms das Steuersignal INCON, durch welches mittels des A/D-Wandlers 60 eine Bezugsgröße für die zweite Harmonische $U_1$ in den Rechner 66 eingegeben und gespeichert wird. Mit Verschwinden des Signals AZ wird durch das Signal $\overline{AZ}$ der Analogschalter 50 geschlossen und die zweite Harmonische $U_1$ gelangt auf den phasenempfindlichen Gleichrichter 44. Nach insgesamt 30 ms, das Filter ist bereits auf seinen Endwert eingeschwungen, wird aufgrund des Signals INCON eine erste A/D-Wandlung und nach insgesamt 40 ms eine zweite A/D-Wandlung initiiert, und die derart erhaltenen digitalen Signale werden in den Rechner 66 eingegeben. Diese digitalen Signale werden addiert und durch den Faktor zwei dividiert, wodurch in bevorzugter Weise Netzmodulationen von beispielsweise 50 Hz unterdrückt werden. Mittels des Rechners 66 wird nunmehr aus der halben Summe der genannten digitalen Signale und der gespeicherten Bezugsgröße ein erstes Differenzsignal gebildet, welches nach Vorzeichen der Phasenlage und nach Betrag der Amplitude der zweiten Harmonischen $U_1$ und somit der Feldkomponente in Richtung der Hauptachsen der Abgriffspulen 31, 32 entspricht.

Nach insgesamt 50 ms verschwindet das Steuersignal UM und durch das nunmehr am Analogschalter 41 anstehende Steuersignale $\overline{UM}$ wird für die nächsten 50 ms die Signalspannung $S_2$ auf das Filter 42 gegeben. Es wird entsprechend den obigen Ausführungen für die zweite Harmonische $U_2$ ein zweites Differenzsignal gebildet, welches der Feldkomponente in Richtung der Hauptachsen der Abgriffspulen 33, 34 entspricht. Da die Hauptachsen der Abgriffspulen 31, 32 zu denen der Abgriffspulen 33, 34 um 90° versetzt sind, wird mittels des Rechners 66 über eine arctan-Rechnung aus den beiden Differenzsignalen der Winkelwert des in der Meßebene einwirkenden externen Magnetfeldes und somit die Richtung der Horizontalkomponente dieses Magnetfeldes, z. B. des Erdmagnetfeldes, bestimmt.

## Patentansprüche

1. Vorrichtung zum Erfassen eines Magnetfeldes, enthaltend einen dünnen, im wesentlichen ringförmigen Kern (24) aus magnetischen Material, welcher von einer Erregerspule (30) und von -vorzugsweise vier-achssymmetrisch angeordneten Abgriffspulen (31 bis 34) umgeben ist, eine Auswerteschaltung für die Signalspannungen der Abgriffspulen (31 bis 34) und einen ringförmigen Spulenkörper (20), der in einer Stirnfläche eine Ringnut (23) zur Aufnahme des Kernes (24) aufweist, dadurch gekennzeichnet, daß Nuten (27, 28), die wenigstens teilweise um den Spulenkörper (20) verlaufen und deren Symmetrieebenen in um bestimmte Teilungen verdrehten Ebenen, die auch die Spulenkörperlängsachse beinhalten, liegen und von der den Kern (24) aufnehmenden Ringnut (23) senkrecht durchstoßen werden, zur Aufnahme der Erregerspule (30) und der Abgriffspulen (31 bis 34), vorgesehen sind und daß mit dem Spulenkörper (20) ein Deckel (21) verbunden ist, dessen ringförmiger Ansatz (25) in die Ringnut (23) zur Fixierung des Kernes (24) hineinragt, wobei der Kern (24) als eine einzige Ringscheibe ausgebildet ist.

2. Vorrichtung nach Anspruch 1, dadurch gekennzeichnet, daß die Nuten (27, 28) über den Umfang des Spulenkörpers (20), in den vier Quadranten, jeweils achs-symmetrisch angeordnet sind und daß in jedem Quadranten eine der Abgriffspulen (31 bis 34) in gleicher Weise angeordnet ist, so daß deren Hauptachsen um jeweils 90° gegeneinander versetzt liegen.

3. Vorrichtung nach Anspruch 1 oder 2, dadurch gekennzeichnet, daß der Spulenkörper (20) zur kardanischen Aufhängung zwei diametral gegenüberliegende und nach oben gerichtete Bügel (17, 18) aufweist und daß ein Kardanring (10) vorgesehen ist, dessen erste Wellen (13, 14) in Buchsen (15, 16) der genannten Bügel eingreifen und dessen bezüglich der ersten Wellen an seinem Umfang um 90° versetzt angeordnete zweite Wellen (11, 12) in Buchsen (7, 8) des Deckels (2) eingreifen, der das den Spulenkörper (20) aufnehmende Gehäuse (1) oben abschließt.

4. Vorrichtung nach Anspruch 3, dadurch gekennzeichnet, daß die Durchmesser der genannten Buchsen (7, 8, 15, 16) jeweils um etwa 20 % größer sind als die Durchmesser der Wellen (11, 12, 13, 14).

5. Vorrichtung nach einem der vorhergehenden Ansprüche, dadurch gekennzeichnet, daß an der Unterseite des Spulenkörpers (20) ein im wesentlichen kugelabschnittförmiges Pendelgewicht (22) angeordnet ist.

6. Vorrichtung nach einem der vorhergehenden Ansprüche, dadurch gekennzeichnet, daß an der Außenseite eines den Spulenkörper (20) aufnehmenden Gehäuses (1) zwei Wicklungen einer Helmholtzspule (29) vorgesehen sind, welche zur Kompensation der Vertikalkomponente eines Dauermagnetfeldes von einem Gleichstrom durchflossen ist.

7. Vorrichtung nach einem der Ansprüche 1 bis 6, dadurch gekennzeichnet, daß die Auswerteschaltung zur Auswertung der in den jeweils diametral gegenüberliegenden Abgriffspulen (31, 32 bzw. 33, 34) auftretenden Signalspannungen ($S_1$, $S_2$) einen phasenempfindlichen Gleichrichter (44) enthält, welchem die Signalspannungen ($S_1$, $S_2$) abwechselnd über Analogschalter (40, 41) zugeführt werden, und daß dem phasenempfindlichen Gleichrichter (44) ein Filter (42) vorgeschaltet ist, welches nur für die zweite Harmonische ($U_1$ bzw. $U_2$) der Erregerfrequenz durchlässig ist.

8. Vorrichtung nach Anspruch 7, dadurch gekennzeichnet, daß ein Oszillator (37) vorgesehen ist, aus dessen frequenzstabiler Impulsfolge-vorzugsweise über Teiler (38, 39)-sowohl eine Frequenz (SF) für eine Ansteuerschaltung (36), mit welcher die Erregerspule (30) angesteuert wird, als auch Steuersignale (UM, DEMO, AZ) für die Analogschalter (40, 41) und den phasenempfindlichen Gleichrichter (44) abgeleitet werden.

9. Vorrichtung nach einem der Ansprüche 7 oder 8, dadurch gekennzeichnet, daß dem phasenempfindlichen Gleichrichter (44) über einen Analog-Digital-Wandler (60) ein Rechner (66) nachgeschaltet ist, mit welchem aus den Signalspannungen ($S_1$, $S_2$) entsprechend der Amplitude und Phasenlage der zweiten Harmonischen ($U_1$ bzw. $U_2$) die Richtung des auf die Abgriffspulen (31 bis 34) einwirkenden Magnetfeldes bestimmbar ist.

10. Vorrichtung nach Anspruch 9, dadurch gekennzeichnet, daß jeweils nach Umschalten eines Analogschalters (40 bzw. 41) durch das Steuersignal (AZ) ein weiterer Analogschalter (51) betätigt und eine aus einem Nullabgleich gebildete Bezugsgröße für die zweite Harmonische ($U_1$ bzw. $U_2$) in den Rechner (66) eingegeben und gespeichert wird und daß unter Berücksichtigung der Einschwingzeit des Filters (42) durch das Steuersignal ($\overline{AZ}$) zur Eingabe der gefilterten und analog/digital gewandelten zweiten Harmonischen ($U_1$ bzw. $U_2$) in den Rechner ein anderer weiterer Analogschalter (50) betätigt wird, wobei der Rechner aus dem zu ihm nunmehr gelangenden Signal und der gespeicherten Bezugsgröße ein Differenzsignal bildet, welches nach Vorzeichen der Phasenlage und nach Betrag der Amplitude der zweiten Harmonischen ($U_1$ bzw. $U_2$) entspricht.

**Claims**

1. An instrument for detecting a magnetic field, containing a thin, substantially annular core (24) of magnetic material which is surrounded by an exciter coil (30) and by — preferably four — pick-up coils (31 to 34) which are disposed axially symmetrically, an evaluation circuit for the signal voltages of the pick-up coils (31 to 34) and an annular coil former (20) which comprises an annular groove (23) in one face to receive the core (24), characterised in that slots (27, 28), which extend at least partially round the coil former (20) and the planes of symmetry of which lie in planes which are turned through specific divisions and which also contain the longitudinal axis of the coil former, which slots are penetrated perpendicularly by the annular groove (23) receiving the core (24), are provided to receive the exciter coil (30) and the pick-up coils (31 to 34), and that connected to the coil former (20) is a cover (21), the annular extension (25) of which projects into the annular groove (23) to locate the core (24), the core (24) being constructed in the form of a single annular disc.

2. An instrument as claimed in Claim 1, characterised in that the slots (27, 28) are disposed over the circumference of the coil former (20), in the four quadrants, axially symmetrically in each case, and that one of the pick-up coils (31 to 34) is disposed in each quadrant in the same manner so that their major axes are each offset by 90° in relation to one another.

3. An instrument as claimed in Claim 1 or 2, characterised in that the coil former (20) comprises two yokes (17, 18) which are situated diametrically opposite one another and directed upwards for the Cardanic suspension and that a Cardan ring (10) is provided, the first shafts (13, 14) of which engage in bushes (15, 16) in the said yokes, and of which the second shafts (11, 12), which are disposed offset by 90° at its circumference in relation to the first shafts, engage in bushes (7, 8) in the cover (2) which closes the housing (1) receiving the coil former (20) at the top.

4. An instrument as claimed in Claim 3, characterised in that the diameter of the said bushes (7, 8, 15, 16) are each larger, by about 20 %, than the diameters of the shafts (11, 12, 13, 14).

5. An instrument as claimed in one of the preceding Claims, characterised in that a pendulum weight (22) having substantially the shape of a part of a sphere, is disposed at the underside of the coil former (20).

6. An instrument as claimed in one of the preceding Claims, characterised in that two windings of a Helmholz coil (29), through which a direct current flows to compensate for the vertical component of a permanent magnetic field, are provided at the outside of the housing (1) receiving the coil former (20).

7. An instrument as claimed in one of the Claims 1 to 6, characterised in that the evaluation circuit to evaluate the signal voltages ($S_1$, $S_2$) appearing in the diametrally oposite pick-up coils (31, 32 or 33, 34) contains a phase sensitive rectifier (44) to which the signal voltages ($S_1$, $S_2$) are supplied alternately through the analogue switches (40, 41), and that the phase-sensitive rectifier (44) is preceded by a filter (42) which only passes the second harmonic ($U_1$ or $U_2$) of the exciter frequency.

8. An instrument as claimed in Claim 7, characterised in that an oscillator 37 is provided from the frequency-stable pulse train of which there are derived — preferably through dividers (38, 39) — both a frequency (SF) for a driving circuit (36) whereby the exciter coil (30) is driven, and control signals (UM, DEMO, AZ) for the analogue switch (40, 41) and the phase-sensitive rectifier (44).

9. An instrument as claimed in one of the Claims 7 or 8, characterised in that the phase-sensitivie rectifier (44) is followed, via an analogue-digital converter (60), by a computer (66) with which the direction of the magnetic field acting on the pick-up coils (31, 34) can be determined from the signal voltages ($S_1$, $S_2$) according to the amplitude and phase position of the second harmonic ($U_1$ or $U_2$).

10. An instrument as claimed in Claim 9, characterised in that, after each switching over of an analogue switch (40 or 41), a further analogue switch (51) is actuated by the control signal (AZ) and a reference quantity for the second harmonic ($U_1$ or $U_2$), formed from a zero adjustment, is fed into the computer (66) and stored, and that, taking into consideration the transient time of the filter (42), another further analogue switch (50) is actuated by the control signal (AZ) for the input of the filtered and analogue-digital converted second harmonic ($U_1$ or $U_2$) into the computer, and the computer forms, from the signal now reaching it and the stored reference quantity, a difference signal which corresponds in sign to the phase position and in amount to the amplitude of the second harmonic ($U_1$ or $U_2$).

**Revendications**

1. Dispositif pour enregistrer un champ magnétique, contenant un noyau mince de forme essentiellement annulaire (24) se composant d'un matériau magnétique et qui est entouré par une bobine d'excitation (30) et par des bobines de prise (31 à 34) disposées de préférence avec une symétrie à quatre axes, un circuit d'évaluation des tensions de signal provenant des bobines de prise (31 à 34) et un corps annulaire de support de bobines (20), qui comporte dans une surface frontale une rainure annulaire (23) servant à recevoir le noyau (24), caractérisé en ce qu'il est prévu des rainures (27, 28), qui sont disposées au moins en partie autour du corps de support de bobines (20) et dont les plans de symétrie sont placés dans des plans tournés d'échelons déterminés et qui contiennent également l'axe longitudinal du corps de support de bobines en étant traversés perpendiculairement par la rainure annulaire (23) recevant le noyau (24) en vue de la réception de la bobine d'excitation (30) et des bobines de prise (31 à 34), et en ce que le corps de support de bobines (20) est relié à un couvercle (21) dont un appendice de forme annulaire (25) pénètre dans la rainure annulaire (23) pour la fixation du noyau (24), ce noyau (24) étant agencé sous la forme d'un seul disque annulaire.

2. Dispositif selon la revendication 1, caractérisé en ce que les rainures (27, 28) sont disposées sur la périphérie du corps de support de bobines (20) dans les quatre quadrants et respectivement avec une symétrie axiale et en ce que dans chaque quadrant une des bobines de prise (31 à 34) est disposée de la même manière de façon que leurs axes principaux soient respectivement décalés entre eux de 90°.

3. Dispositif selon la revendication 1 ou 2, caractérisé en ce que le corps de support de bobines (20) comporte, en vue d'une suspension à cardan, deux étriers (17, 18) placés dans des positions diamétralement opposées et dirigés vers le haut et en ce qu'il est prévu un anneau de cardan (10) dont les premiers arbres (13, 14) sont engagés dans des coussinets (15, 16) des étriers précités et dont des seconds arbres (11, 12) disposés sur sa périphérie avec un décalage de 90° par rapport aux premiers arbres sont engagés dans des coussinets (7, 8) du couvercle (2), qui ferme à la partie supérieure le carter (1) recevant le corps de support de bobines.

4. Dispositif selon la revendication 3, caractérisé en ce que les diamètres des coussinets précités (7, 8, 15, 16) sont respectivement supérieurs d'environ 20 % aux diamètres des arbres (11, 12, 13, 14).

5. Dispositif selon une des revendications précédentes, caractérisé en ce qu'il est prévu sur le côté inférieur du corps de support de bobines (20) un poids pendulaire (22) sensiblement en forme de partie de sphère.

6. Dispositif selon une des revendications précédentes, caractérisé en ce qu'il est prévu sur le côté extérieur d'un carter (1) recevant le corps de support de bobines (20) deux enroulements d'une bobine de Helmholtz, (29), qui est parcourue par un courant continu en vue d'une compensation de la composante verticale d'un champ magnétique permanent.

7. Dispositif selon une des revendications 1 à 6, caractérisé en ce que le circuit d'évaluation servant à évaluer les tensions de signal ($S_1$, $S_2$) se produisant dans les bobines de prise (31, 32 et 33, 34) respectivement placées dans des positions diamétralement opposées contient un redresseur (44) sensible à la phase, auquel sont appliquées les tensions de signal ($S_1$, $S_2$) alternativement par l'intermédiaire de commutateurs analogiques (40, 41) et en ce qu'il est prévu en série avec le redresseur (44) sensible à la phase un filtre (42) qui ne laisse passer que la seconde harmonique ($U_1$ ou $U_2$) de la fréquence d'excitation.

8. Dispositif selon la revendication 7, caractérisé en ce qu'il est prévu un oscillateur (37) qui produit une séquence d'impulsions stables en fréquence à partir desquelles on dérive — de préférence par l'intermédiaire de diviseurs (38, 39) — d'une part une fréquence (SF) pour un circuit de commande (36) à l'aide duquel la bobine d'excitation (30) est commandée et d'autre part des signaux de commande (UM, DEMO, AZ) pour les commutateurs analogiques (40, 41) et le redresseur sensible à la phase (44).

9. Dispositif selon une des revendications 7 ou 8, caractérisé en ce qu'il est prévu en série avec le redresseur (44) sensible à la phase, par l'intermédiaire d'un convertisseur analogique-numérique (60), un calculateur (66) à l'aide duquel peut être déterminée la direction du champ magnétique agissant sur les bobines de prise (31 à 34) à partir des tensions de signal ($S_1$, $S_2$) et en correspondance à l'amplitude et au phasage de la seconde harmonique ($U_1$ ou $U_2$).

10. Dispositif selon la revendication 9, caractérisé en ce qu'à chaque fois après commutation d'un commutateur analogique (40 ou 41), un autre commutateur analogique (51) est actionné par le signal de commande (AZ) et une grandeur de référence de la seconde harmonique ($U_1$ ou $U_2$), établie à partir d'une compensation de zéro, est introduite et mémorisée dans le calculateur (66) et en ce que, en tenant compte du temps d'oscillation du filtre (42), le signal de commande ($\overline{AZ}$) assure l'actionnement d'un autre commutateur analogique (50) en vue de l'introduction de la seconde harmonique ($U_1$ ou $U_2$) filtrée et soumise à une conversion analogique/numérique dans le calculateur, ce calculateur établissant à partir du signal qui lui est maintenant appliqué et de la grandeur de référence mémorisée un signal de différence qui correspond au signe du phasage et à la valeur d'amplitude de la seconde harmonique ($U_1$ ou $U_2$).

FIG.1

FIG.2

FIG.3

0 059 770

FIG.4

0 059 770